# EUROPÄISCHE PATENTSCHRIFT

(11) **EP 1 242 826 B1**
(45) Veröffentlichungstag und Bekanntmachung des Hinweises auf die Patenterteilung: **30.03.2005**
(21) Anmeldenummer: 00969205.4
(22) Anmeldetag: 25.08.2000
(51) Int. Cl.: G01P 15/08

(54) **BESCHLEUNIGUNGSSENSOR MIT EINGESCHRÄNKTER BEWEGLICHKEIT IN VERTIKALER RICHTUNG**
ACCELERATION SENSOR WITH LIMITED MOVABILITY IN THE VERTICAL DIRECTION
CAPTEUR D'ACCELERATION A MOBILITE LIMITEE DANS LE SENS VERTICAL

(30) Priorität: 15.10.1999 DE 19949605
(43) Veröffentlichungstag der Anmeldung: 25.09.2002
(73) Patentinhaber: ROBERT BOSCH GMBH, 70442 Stuttgart (DE)
(72) Erfinder: RETTIG, Rasmus, 70839 Gerlingen (DE); KOHN, Oliver, 72770 Reutlingen (DE); FISCHER, Frank, 72810 Gomaringen (DE); SCHUBERT, Dietrich, 72762 Reutlingen (DE)
(86) Internationale Anmeldenummer: PCT/DE2000/002913
(87) Internationale Veröffentlichungsnummer: WO 2001/029565

(56) Entgegenhaltungen:
- EP-A- 0 766 089
- WO-A-99/12002
- DE-A- 3 920 645
- DE-A- 19 830 476
- US-A- 5 121 633

## Beschreibung

Die Erfindung betrifft einen Beschleunigungssensor mit den im Oberbegriff des Anspruchs 1 genannten Merkmalen.

### Stand der Technik

Beschleunigungssensoren der gattungsgemäßen Art sind bekannt. Diese weisen eine an einem Substrat beweglich aufgehängte Schwingstruktur als seismische Masse auf. Infolge einer einwirkenden Beschleunigung wird diese seismische Masse ausgelenkt und verändert ihre relative Position zu dem Substrat. Der seismischen Masse sind Auswertemittel zugeordnet, die den Grad der beschleunigungsbedingten Auslenkung erfassen. Als Auswertemittel sind beispielsweise piezoresistive, kapazitive oder frequenzanaloge Auswerteanordnungen bekannt. Bei den kapazitiven Auswertemitteln ist die seismische Masse mit einer Kammstruktur versehen, die mit einer feststehenden, das heißt mit dem Substrat verbundenen, Kammstruktur zusammenwirkt. Zwischen den einzelnen Stegen der Kammstrukturen kommt es zur Ausbildung von Kapazitäten, deren Größen sich mit einer Auslenkung der seismischen Masse verändern.

Über Auswerteschaltungen können diese Kapazitätsänderungen erfaßt werden und so eine an dem Beschleunigungssensor einwirkende Beschleunigung detektiert werden.

Eine Schwingebene der Schwingstruktur, innerhalb der die beschleunigungsbedingte Auslenkung erfolgt, liegt bekanntermaßen in einer Substratebene. Bekannt ist, der Schwingstruktur lateral wirkende Anschläge zuzuordnen, die ein Aufschlagen der mit der Schwingstruktur verbundenen Kammstruktur auf die feststehende, mit dem Substrat verbundene Kammstruktur verhindern soll. Hierdurch werden mechanische Zerst-örungen-der Kammstrukturen vermieden.

Bei den bekannten Beschleunigungssensoren ist nachteilig, daß eine im wesentlichen senkrecht zur Schwingebene einwirkende Beschleunigung zu einem Auslenken der Schwingstruktur aus der Schwingebene führen kann. Bei entsprechend großer einwirkender, im wesentlichen senkrecht zur Schwingebene wirkender Beschleunigung kann die Schwingstruktur aus den vorhandenen lateralen Führungsstrukturen herausspringen, so daß eine Funktion des Beschleunigungssensors beeinträchtigt beziehungsweise ausgeschlossen ist. Da derartige Beschleunigungssensoren beispielsweise in sicherheitsrelevanten Ausrüstungen von Kraftfahrzeugen eingesetzt werden, beispielsweise zum Auslösen von Airbags, Gurtstraffern oder dergleichen, ist eine Fehlfunktion mit einem erheblichen Sicherheitsrisiko verbunden.

Aus der WO-A- 99/12002 ist eine Struktur bekannt, bei der durch Anschläge Auslenkungen in alle Richtungen begrenzt sind.

### Vorteile der Erfindung

Der erfindungsgemäße Beschleunigungssensor mit den im Anspruch 1 genannten Merkmalen bietet demgegenüber den Vorteil, daß eine Funktionsfähigkeit des Beschleunigungssensors aufgrund im wesentlichen senkrecht zur Schwingebene angreifender Beschleunigungskräfte nicht beeinträchtigt wird. Dadurch, daß Anschlagmittel vorgesehen sind, die eine im wesentlichen senkrecht zur Schwingebene der Schwingstruktur liegende Auslenkbewegung der Schwingstruktur begrenzen, wird vorteilhaft erreicht, daß bei einem Angreifen an sich nicht zu detektierender, im wesentlichen senkrecht zur Schwingebene liegender Beschleunigungskräfte die Schwingstruktur nicht aus ihren lateralen Führungsstrukturen herausspringen kann. Die Anschlagmittel bilden somit neben den bekannten lateralen Führungsstrukturen zusätzliche, senkrecht (vertikal) zur Schwingebene wirkende Führungsstrukturen.

In bevorzugter Ausgestaltung der Erfindung ist vorgesehen, daß die vertikal wirkenden Anschlagmittel unterhalb der Schwingstruktur angeordnet sind. Hierdurch wird erreicht, daß diese Anschlagmittel in den Beschleunigungssensor integriert sind, so daß eine zusätzliche Bauhöhe nicht notwendig ist. Insbesondere ist bevorzugt, daß die Anschlagmittel kraftschlüssig mit der Schwingstruktur verbunden sind, wobei ein mit dem Substrat kraftschlüssig verbundenes Element einen Gegenanschlag bildet. Hierdurch wird eine Integration der Anschlagmittel in das Sensorelement besonders einfach möglich. Bevorzugt ist ferner, wenn das den Gegenanschlag bildende Element eine mit dem Substrat verbundene Auswerteelektrode des Auswertemittels ist. Hierdurch wird vorteilhaft möglich, ein bekanntes und bewährtes Layout des Beschleunigungssensors beizubehalten, so daß sich der Aufwand zur Herstellung der die zusätzlichen vertikal wirkenden Anschlagmittel aufweisenden Beschleunigungssensoren im wesentlichen nicht erhöht.

Weitere bevorzugte Ausgestaltungen der Erfindung ergeben sich aus den übrigen, in den Unteransprüchen genannten Merkmalen.

### Zeichnungen

Die Erfindung wird nachfolgend in Ausführungsbeispielen anhand der zugehörigen Zeichnungen näher erläutert. Es zeigen:
- Figur 1: eine schematische Draufsicht auf einen Beschleunigungssensor in einem ersten Ausführungsbeispiel;
- Figuren 2 bis 6: schematisch einzelne Verfahrensschritte zum Erzielen eines vertikale Anschlagmittel aufweisenden Beschleunigungssensors;
- Figur 7: eine schematische Draufsicht auf den Beschleunigungssensor mit integrierten vertikalen Anschlagmitteln;
- Figur 8: eine schematische Detailvergrößerung der Anordnung vertikaler Anschlagmittel in einer weiteren Ausführungsvariante und
- Figuren 9 und 10: die Anordnung vertikaler Anschlagmittel an einen Beschleunigungssensor in einer weiteren Ausführungsvariante.

### Beschreibung der Ausführungsbeispiele

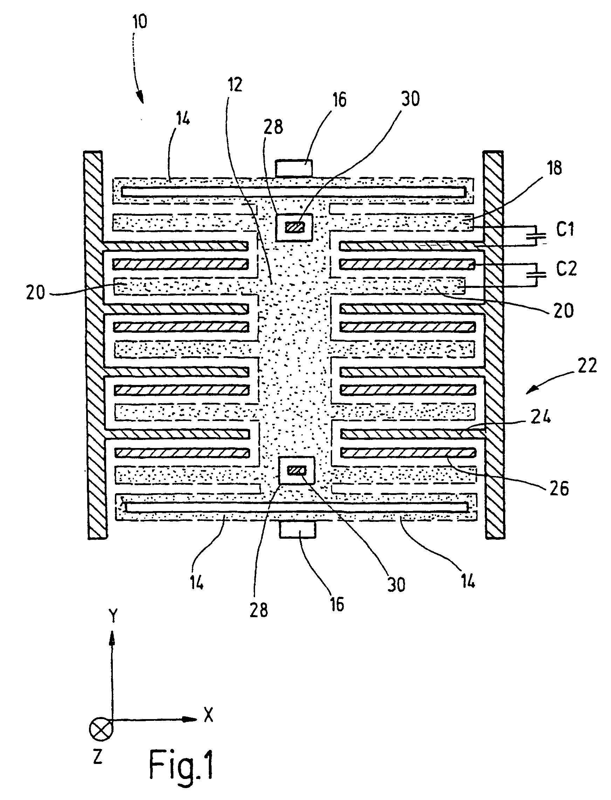

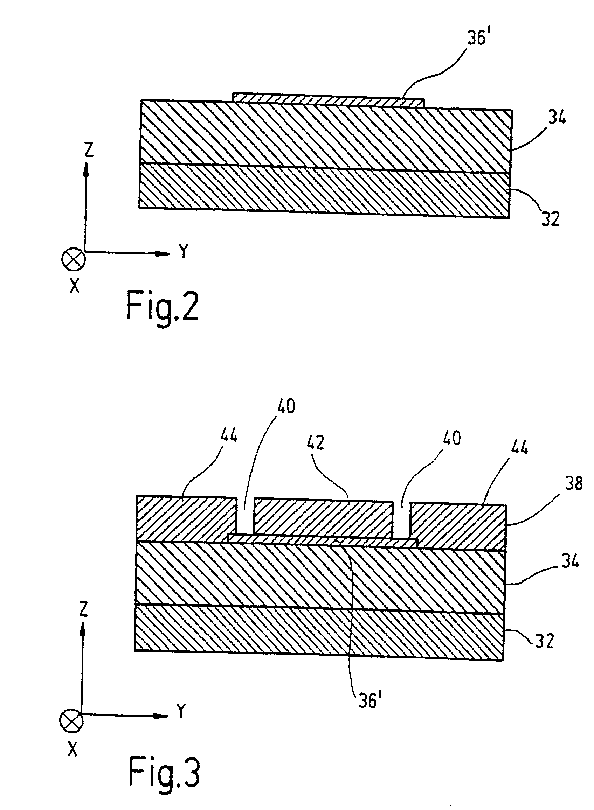

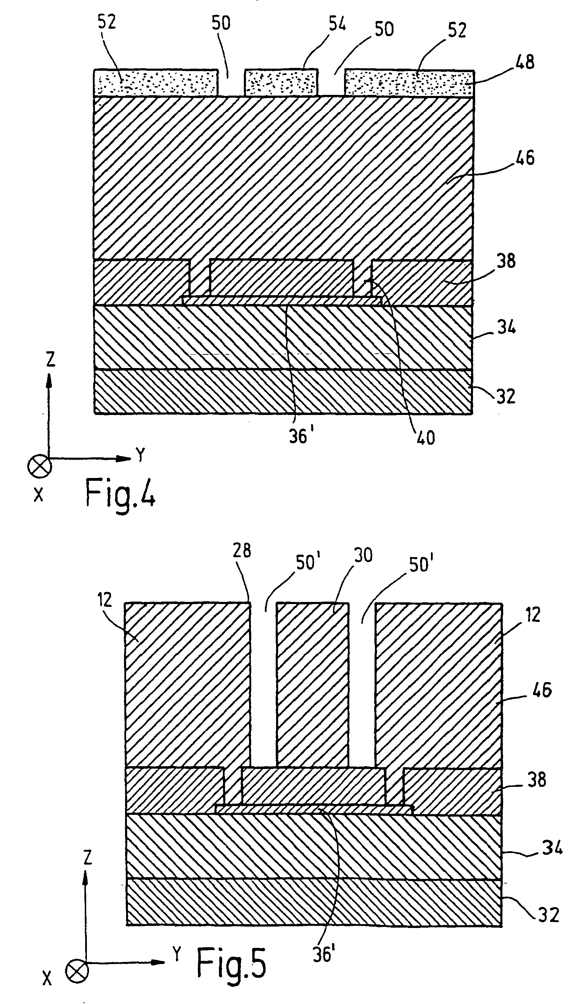

In Figur 1 ist in Draufsicht das Design eines Beschleunigungssensors 10 gezeigt. Der Beschleunigungssensor 10 ist auf einem, im einzelnen nicht dargestellten Substrat, beispielsweise einem Wafer, strukturiert. Die Strukturierung kann mittels bekannter Verfahren der Oberflächenmikromechanik erfolgen. In der gezeigten Darstellung wird der Wafer von der Papierebene gebildet. Der Wafer kann gleichzeitig hier nicht näher zu betrachtende elektrische Auswerteschaltungen für den Beschleunigungssensor 10 aufweisen.

Der Beschleunigungssensor 10 besitzt eine Schwingstruktur 12, die als seismische Masse ausgebildet ist. Die Schwingstruktur 12 ist gegenüber dem Substrat (Wafer) beweglich aufgehängt. Hierzu ist die Schwingstruktur 12 mit Federelementen 14 gekoppelt, die über Befestigungspunkte 16 mit dem Substrat verbunden sind. Diese Befestigungspunkte 16 tragen die gesamte, ansonsten freischwebend über dem Substrat angeordnete Anordnung der Schwingstruktur 12 und der Federelemente 14. Dies kann mittels bekannter Verfahrensschritte der Herstellung von Oberflächenmikromechanik-Strukturen erfolgen, wobei die freischwingenden Bereiche unterätzt werden, so daß sich zwischen dem Substrat und der Schwingstruktur 12 beziehungsweise den Federelementen 14 ein geringfügiger Spalt ergibt.

Die Schwingstruktur 12 besitzt beidseitig eine Kammstruktur 18, die von senkrecht zur Oberfläche des Substrates angeordneten Fingern 20 gebildet wird. Die Kammstrukturen 18 sind starr ausgebildet, so daß bei einer Bewegung der Schwingstruktur 12 diese mit der Schwingstruktur 12 starr mitschwingen.

Der Beschleunigungssensor 10 weist weiterhin Auswertemittel 22 auf, die von feststehenden Kammstrukturen gebildet werden. Diese umfassen Elektroden 24 und Elektroden 26, die vom Substrat (Wafer) entspringen und zwischen den Fingern 20 der Schwingstruktur 12 angeordnet sind. Zwischen den Elektroden 24 und den Fingern 20 sind Kapazitäten C1 und zwischen den Elektroden 26 und den Fingern 20 Kapazitäten C2 ausgebildet. Hierzu sind die Elektroden 24 und 26 und die Schwingstruktur 12 über die Befestigungspunkte 16 mit einer nicht näher dargestellten Auswerteschaltung verbunden. Die Kapazitäten C1 und C2 werden durch eine Abstand der Finger 20 zu den Elektroden 24 beziehungsweise 26 bestimmt. Da das gesamte Material des Beschleunigungssensors 10 aus einem elektrisch leitenden Material, beispielsweise Silizium, besteht, können die Kapazitäten C1 und C2 in das Substrat und somit in die nicht näher dargestellte Auswerteschaltung eingebunden werden.

Die Schwingstruktur 12 besitzt Ausnehmungen 28, in die jeweils ein mit dem Substrat (Wafer) verbundener Lateralanschlag 30 eingreift.

Der Beschleunigungssensor 10 zeigt folgende, an sich bekannte Funktion. Zur Verdeutlichung ist in einem Koordinatensystem eine x-, y- und z-Achse eingetragen. Die x- und y-Achsen definieren hierbei die Schwingungsebene der Schwingstruktur 12, die gemäß Darstellung in Figur 1 mit der Papierebene zusammenfällt. Die z-Achse verläuft senkrecht zu der Schwingebene. Bei ihrem bestimmungsgemäßen Einsatz werden die Beschleunigungssensoren 10 so plaziert, daß eine angreifende, in y-Richtung wirkende Beschleunigung detektierbar ist. Greift eine derartige Beschleunigung an dem Beschleunigungssensor 10 an, wird die Schwingstruktur 12 in y-Richtung ausgelenkt. Hierdurch verändern sich die Abstände zwischen den Fingern 20 einerseits und den Elektroden 24 beziehungsweise 26 andererseits. Durch die hiermit verbundene Änderung der Kapazitäten C1 und C2 kann eine, der angreifenden Beschleunigung proportionale Spannungsgröße ermittelt werden, die für weitere Auswertungen zur Verfügung steht.

Anhand der nachfolgenden Figuren wird die erfindungsgemäße Modifizierung des in Figur 1 dargestellten, an sich bekannten Beschleunigungssensors 10 beschrieben. Erfindungsgemäß ist vorgesehen, daß zusätzlich zu den Lateralanschlägen 30 vertikale Anschlagmittel integriert werden. Diese verhindern, daß die Schwingstruktur 12 in Richtung der z-Achse über ein vorgebbares Maß hinaus ausgelenkt wird.

In den Figuren 2 bis 6 ist jeweils eine Schnittdarstellung durch den Beschleunigungssensor 10 während einzelner Verfahrensschritte zur Herstellung des Beschleunigungssensors 10 gezeigt. In den Figuren 2 bis 6 ist der Beschleunigungssensor 10 lediglich ausschnittsweise im Bereich der späteren Ausnehmungen 28 der Schwingstrukturen 12 gezeigt. Zur Orientierung sind wiederum jeweils die x-, y- und z-Achsen eingetragen. Die einzelnen Verfahrensschritte zum Strukturieren des Beschleunigungssensors 10 sind an sich bekannt, so daß hierauf im einzelnen nicht näher eingegangen wird.

Zunächst wird, wie Figur 2 zeigt, auf einem Ausgangswafer 32 eine Isolationsschicht 34 erzeugt. Diese Isolationsschicht 34 kann beispielsweise ein thermisches Siliziumoxid SiO₂ oder ein Bor-Phosphor-Silikat-Glas sein. Die Schichtdicke der Isolationsschicht 34 beträgt beispielsweise zwischen 0,5 µm und 3 µm. Auf die Isolationsschicht 34 wird eine Leiterbahnschicht 36', beispielsweise mittels eines CVD (chemical vapor deposition)-Verfahren abgeschieden. Die Leiterbahnschicht 36' besitzt beispielsweise eine Schichtdicke zwischen 0,3 µm und 2 µm.

Wie Figur 3 verdeutlicht, wird anschließend eine Opferschicht 38 aufgebracht. Die Opferschicht 38 besteht beispielsweise aus Siliziumoxid SiO₂ oder Bor-Phosphor-Silikat-Glas. In diese Opferschicht 38 werden zunächst grabenförmige Öffnungen 40 eingebracht, so daß ein mittlerer Bereich 42 und äußere Bereiche 44 entstehen. Die grabenförmige Öffnungen 40 erstrecken sich bis auf die Leiterbahnschicht 36'.

Nachfolgend wird, wie Figur 4 verdeutlicht, eine weitere Funktionsschicht 46 abgeschieden, die beispielsweise eine Dicke zwischen 2 µm und 20 µm besitzt. Durch das vorhergehende Strukturieren der grabenförmigen Öffnungen 40 wird die Funktionsschicht 46 auch in die grabenförmigen Öffnungen 40 abgeschieden, so daß eine Kontaktierung mit der Leiterbahnschicht 36' erfolgt. Auf die Funktionsschicht 46 wird eine weitere Maskierungsschicht 48 abgeschieden. In diese Maskierungsschicht 48 werden entsprechend dem späteren Design des Beschleunigungssensors 10 grabenförmige Vertiefungen 50 eingebracht, die Bereiche 52 und Bereiche 54 der Maskierungsschicht 48 definieren. Die Bereiche 52 überdecken die Funktionsschicht 46 in späteren beweglich angeordneten Strukturen des Beschleunigungssensors 10, während die Bereiche 54 Abschnitte der Funktionsschicht 46 überdecken, die spätere, mit dem Substrat verbundene feststehende Bereiche des Beschleunigungssensors 10 definieren.

Nachfolgend erfolgt ein selektives anisotropes Ätzen der Funktionsschicht 46 durch die grabenförmigen Öffnungen 50 - wie Figur 5 verdeutlicht. In einem nachfolgenden Prozeßschritt wird die Maskierungsschicht 48 entfernt. Das selektive anisotrope Ätzen der Gräben 50' stoppt automatisch an der Opferschicht 38. Durch das Ätzen der Gräben 50' wird die spätere Ausnehmung 28 des Beschleunigungssensors 10 definiert, die innerhalb der Schwingmasse 12 angeordnet ist und in die der spätere Lateralanschlag 30 eingreift.

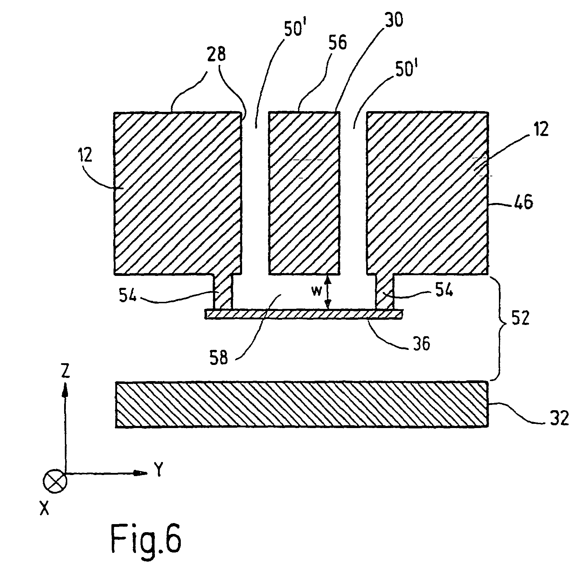

Figur 6 verdeutlicht, daß in einem nächsten Arbeitsschritt die Opferschicht 38 und die Isolationsschicht 34 selektiv entfernt (geätzt) werden, so daß sich zwischen der Schwingstruktur 12 und dem Ausgangswafer 32 ein Spalt 52 ergibt, der dazu führt, daß die Schwingstruktur 12 über dem Ausgangswafer 32 (Substrat) beweglich aufgehängt ist (über die Federelemente 14 gemäß Figur 1). Durch das selektive Ätzen der Opferschicht 38 und der Isolationsschicht 34 verbleibt die Leiterbahnschicht 36', die über Verbindungselemente 54 mit der Schwingstruktur 12 kraftschlüssig verbunden ist. Die Verbindungselemente 54 entsprechen der Auffüllung der Funktionsschicht 46 in die grabenförmigen Öffnungen 40 (Figur 4). Gleichzeitig wird der gemäß der Schnittdarstellungen in den Figuren 2 bis 6 dargestellte Abschnitt 56 des Lateralanschlages 30 unterätzt, so daß sich zwischen Leiterbahnschicht 36' und Abschnitt 56 ein Spalt 58 mit einer Spaltweite w ergibt. Die Spaltweite w ergibt sich aus der Dicke der Opferschicht 38. Die Leiterbahnschicht 36' bildet nunmehr ein nachfolgend mit 36 bezeichnetes Anschlagmittel.

Durch das Freilegen der Schwingstruktur 12 ist das Anschlagmittel 36 unterhalb des ebenfalls freigelegten Abschnittes 56 des Lateralanschlages 30 angeordnet. Somit ergibt sich, daß Lateralanschlag 30 einerseits eine Auslenkung der Schwingstruktur 12 in der x- beziehungsweise y-Richtung entsprechend der Anordnung der Ausnehmung 28 begrenzt. Ferner wird gleichzeitig durch den Abschnitt 56 des Lateralanschlages 30 die Auslenkung der Schwingstruktur 12 in der z-Richtung begrenzt. Die maximale Auslenkung der Schwingstruktur 12 in z-Richtung ergibt sich durch die Spaltweite w des Spaltes 58. Hierdurch wird verhindert, daß durch Auftreten einer Beschleunigungskraft in z-Richtung die Schwingstruktur 12 aus ihrer Schwingebene (Sensierebene) herausspringt und somit die Funktion des Beschleunigungssensors 10 beeinträchtigt ist beziehungsweise nicht mehr gegeben ist.

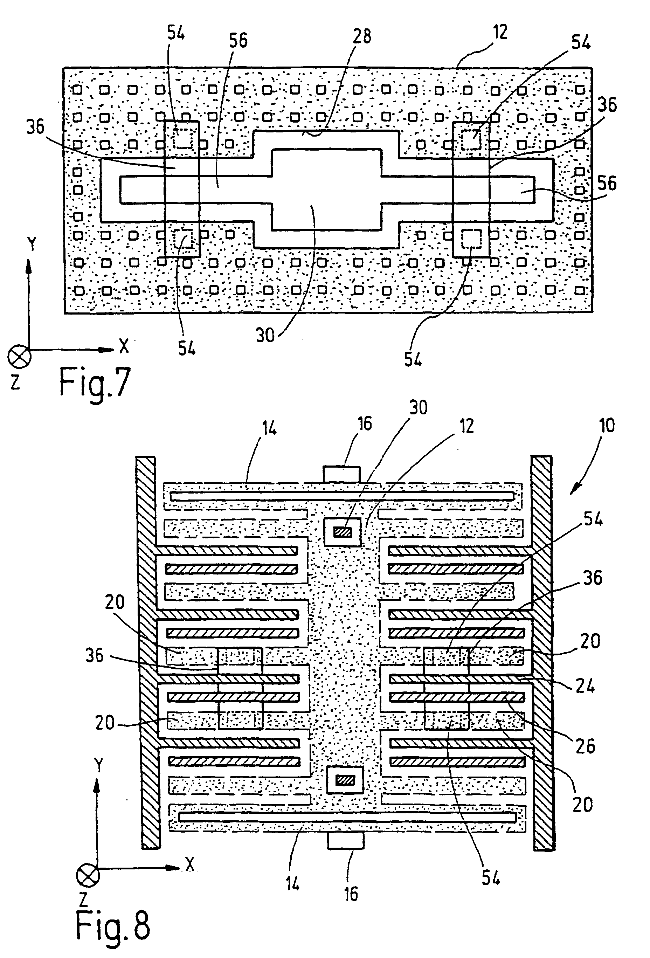

Figur 7 verdeutlicht in einer Detailvergrößerung den Bereich der Schwingstruktur 12, in dem der Lateralanschlag 30 und das Anschlagmittel (Vertikalanschlag) 36 ausgebildet sind.

Es wird deutlich, daß durch geringfügige Änderungen im Design des Beschleunigungssensors 10 das zusätzliche Anschlagmittel 36 und der Gegenanschlag 56 zum Begrenzen einer Vertikalauslenkung der Schwingstruktur 12 geschaffen werden können.

Die in Figur 7 gezeigte Detailvergrößerung der Schwingstruktur 12 im Bereich der Ausnehmung 28 bezieht sich auf wenigstens eine der Ausnehmungen 28, kann jedoch auch vorzugsweise an beiden Ausnehmungen 28 der Schwingstruktur 12 (Figur 1) ausgebildet sein.

In Figur 8 ist ein Beschleunigungssensor 10 nochmals in einer Draufsicht gezeigt, wobei eine weitere Möglichkeit der Ausbildung des Vertikalanschlages gezeigt wird. Während bei den vorhergehenden Ausführungsbeispielen die Leiterbahnschicht 36' über die Verbindungselemente 54 unmittelbar an der Schwingstruktur 12 befestigt sind, kann vorgesehen sein, die Leiterbahnschicht 36' auch unterhalb zweier benachbarter Finger 20 der Schwingstruktur 12 zu strukturieren. Hierbei untergreift nach Wegätzen der Opferschicht 38 - die Leiterbahnschicht 36' die Elektroden 24 und 26 bereichsweise, die mit dem Ausgangswafer 32 (Substrat) kraftschlüssig verbunden sind. Hier wird der Gegenanschlag für die Leiterbahnschicht 36' somit von den Elektroden 24 beziehungsweise 26 gebildet. Die Anordnung der Leiterbahnschicht 36' und somit des Anschlagmittels 36 kann hierbei an gegenüberliegenden Fingern 20 der Schwingstruktur 12 erfolgen.

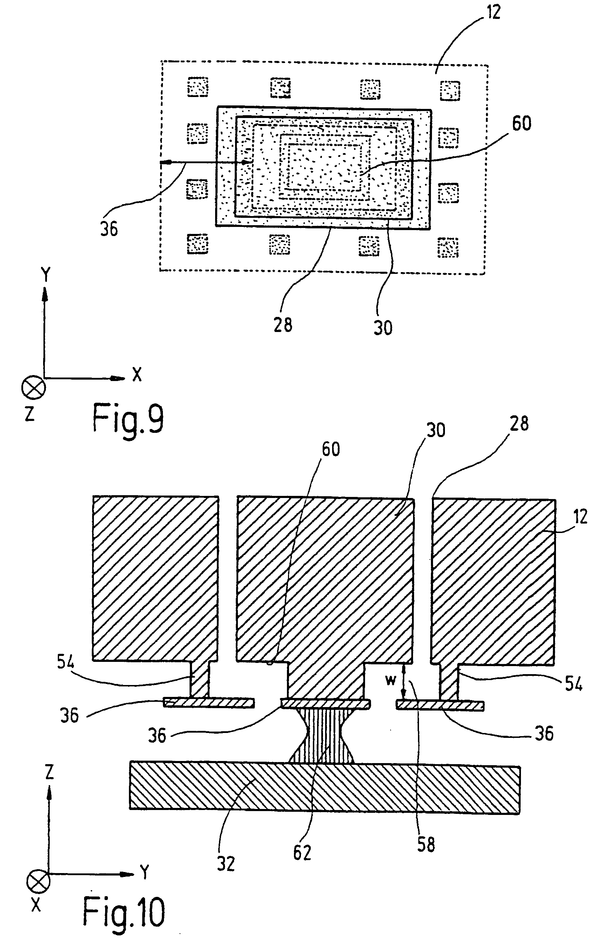

In den Figuren 9 und 10 ist eine weitere Ausführungsvariante zum Ausbilden der in z-Richtung wirkenden Anschlagmittel im Bereich der Lateralanschläge 30 gezeigt. Gleiche Teile wie in den vorhergehenden Figuren sind trotz geringfügiger Abweichungen im Design zum besseren Verständnis mit gleichen Bezugszeichen versehen.

Figur 9 zeigt eine schematische Draufsicht auf die Schwingstruktur 12 im Bereich einer Ausnehmung 28. In die Ausnehmung 28 greift der Lateralanschlag 30 ein. Dieser Lateralanschlag 30 besitzt, wie die Schnittdarstellung in Figur 10 besser verdeutlicht, eine in Richtung des Ausgangswafers (Substrat) 32 verlaufende Ringstufe 60. Die Leiterbahnschicht 36' ist nunmehr derart auf die Isolationsschicht 34 (Figur 2) aufgebracht, daß diese ringförmig um den Lateralanschlag 30 verläuft, wobei die Leiterbahnschicht 36' teilweise in den Bereich der Ringstufe 60 hineinkragt. Der Lateralanschlag 30 ist über eine Oxidbrücke 62 kraftschlüssig mit dem Ausgangswafer 32 verbunden.

Auch durch eine derartige Ausgestaltung wird erreicht, daß einerseits durch das Eingreifen des Lateralanschlages 30 in die Ausnehmung 28 eine Bewegungsbegrenzung der Schwingstruktur 12 in x- und y-Richtung erreicht wird. Durch das ringförmige Umgreifen der Leiterbahnschicht 36' des Lateralanschlages 30 und teilweises Hineinkragen in die Ringstufe 60 ergibt sich dort der Spalt 58 mit der Spaltweite w zu dem Lateralanschlag 30. Hierdurch wird die Beweglichkeit der Schwingstruktur 12 in z-Richtung begrenzt.

## Patentansprüche

1. Beschleunigungssensor mit einer beweglichen, an einem Substrat aufgehängten, aufgrund einer Beschleunigungseinwirkung auslenkbaren Schwingstruktur, wobei eine Schwingebene der Schwingstruktur im wesentlichen parallel zu einer Substratebene und Auswertemittel zum Erfassen einer beschleunigungsbedingten Auslenkung der Schwingstruktur liegt, **gekennzeichnet durch** im wesentlichen senkrecht zur Schwingebene (x-, y-Ebene) der Schwingstruktur (12) liegende, die Auslenkbewegung der Schwingstruktur (12) begrenzende Anschlagmittel (36), wobei die Anschlagmittel (36) kraftschlüssig mit der Schwingstruktur (12) verbunden sind und wobei ein mit dem Substrat (32) kraftschlüssig verbundenes Element (56) einen Gegenanschlag bildet, wobei das Anschlagmittel (36) zwischen der Schwingstruktur (12) und dem Substrat angeordnet ist.

2. Beschleunigungssensor nach Anspruch 1, **dadurch gekennzeichnet, daß** das Anschlagmittel (36) über Verbindungselemente (54) mit der Schwingstruktur (12) verbunden ist.

3. Beschleunigungssensor nach Anspruch 2, **dadurch gekennzeichnet, daß** eine Länge der Verbindungselemente (54) eine Spaltweite (w) eines Spaltes (58) zwischen dem Anschlagmittel (36) der Schwingstruktur (12) und dem Gegenanschlag bestimmt.

4. Beschleunigungssensor nach einem der vorhergehenden Ansprüche, **dadurch gekennzeichnet, daß** der Gegenanschlag von einem Abschnitt (56) eines Lateralanschlages (30) gebildet ist.

5. Beschleunigungssensor nach Anspruch 4, **dadurch gekennzeichnet, daß** der Lateralanschlag zur Ausbildung des Gegenanschlages eine in Richtung des Substrates gerichtete Ringstufe (60) ausbildet.

6. Beschleunigungssensor nach einem der vorhergehenden Ansprüche, **dadurch gekennzeichnet, daß** das Anschlagmittel unter wenigstens zwei benachbarten Fingern (20) der Schwingstruktur (12) angeordnet ist.

7. Beschleunigungssensor nach Anspruch 6, **dadurch gekennzeichnet, daß** der Gegenanschlag von wenigstens einer zwischen den Fingern (20) eingreifenden Elek-0 trode (24, 26) einer Auswerteschaltung des Beschleunigungssensors (10) gebildet ist.

## Claims

1. Acceleration sensor having a movable oscillating structure which is suspended from a substrate and can be deflected owing to an acceleration effect, an oscillation plane of the oscillating structure lying essentially in parallel with a substrate plane and evaluation means for sensing an acceleration-induced deflection of the oscillating structure, **characterized by** stop means (36) which lie essentially perpendicularly to the oscillation plane (x, y plane) of the oscillating structure (12) and which bound the deflection movement of the oscillating structure (12), the stop means (36) being connected in a frictionally locking fashion to the oscillating structure (12), and an element (56) which is connected in a frictionally locking fashion to the substrate (32) forming a corresponding stop, the stop means (36) being arranged between the oscillating structure (12) and the substrate.

2. Acceleration sensor according to Claim 1, **characterized in that** the stop means (36) is connected to the oscillating structure (12) by means of connecting elements (54).

3. Acceleration sensor according to Claim 2, **characterized in that** a length of the connecting elements (54) determines a gap width (w) of a gap (58) between the stop means (36) of the oscillating structure (12) and the corresponding stop.

4. Acceleration sensor according to one of the preceding claims, **characterized in that** the corresponding stop is formed by a section (56) of a lateral stop (30).

5. Acceleration sensor according to Claim 4, **characterized in that** the lateral stop forms an annular step (60), aligned in the direction of the substrate, in order to form the corresponding stop.

6. Acceleration sensor according to one of the preceding claims, **characterized in that** the stop means is arranged under at least two adjacent fingers (20) of the oscillating structure (12).

7. Acceleration sensor according to Claim 6, **characterized in that** the corresponding stop is formed by at least one electrode (24, 26) of an evaluation circuit of the acceleration sensor (10), said electrode (24, 26) engaging between the fingers (20).

## Revendications

1. Capteur d'accélération comportant une structure oscillante, mobile, accrochée à un substrat, et qui peut être déplacée par l'action d'une accélération, un plan d'oscillation de la structure oscillante étant essentiellement parallèle à un plan du substrat et des moyens d'exploitation pour saisir une déviation de la structure oscillante entraînée par l'accélération,
**caractérisé par**
une butée (36) essentiellement perpendiculaire au plan d'oscillation (plan x-, y-) de la structure oscillante (12), limitant le mouvement de débattement de la structure oscillante (12),
la butée (36) étant reliée par une liaison de force à la structure oscillante (12) et
un élément (56) relié par une liaison de force au substrat (32) formant une contrebutée,
la butée (36) se trouvant entre la structure oscillante (12) et le substrat.

2. Capteur d'accélération selon la revendication 1,
**caractérisé en ce que**
la butée (36) est reliée à la structure oscillante (12) par des éléments de liaison (54).

3. Capteur d'accélération selon la revendication 2,
**caractérisé en ce que**
la longueur des éléments de liaison (54) définit la largeur (w) de l'intervalle (58) entre la butée (36) de la structure oscillante (12) et la contrebutée.

4. Capteur d'accélération selon l'une des revendications précédentes,
**caractérisé en ce que**
la contrebutée est formée par un segment (56) d'une butée latérale (30).

5. Capteur d'accélération selon la revendication 4,
**caractérisé en ce que**
la butée latérale comporte un gradin annulaire (60) en direction du substrat pour former la contrebutée.

6. Capteur d'accélération selon l'une des revendications précédentes,
**caractérisé en ce que**
la butée se trouve sous au moins deux doigts voisins (20) de la structure oscillante (12).

7. Capteur d'accélération selon la revendication 6,
**caractérisé en ce que**
la contrebutée est formée par au moins une électrode (24, 26) d'un circuit d'exploitation du capteur d'accélération (10) venant entre les doigts (20).
